# EUROPEAN PATENT SPECIFICATION

(11) **EP 1 342 397 B1**
(45) Date of publication and mention of the grant of the patent: **14.11.2007**
(21) Application number: 01271035.6
(22) Date of filing: 06.12.2001
(51) Int. Cl.: H05K 7/06, H01R 9/24

(54) **CIRCUIT STRUCTURE FOR ELECTRICAL CONNECTION BOX AND METHOD OF FORMING CIRCUIT THEREOF**
SCHALTUNGSANORDNUNG FÜR ELEKTRISCHE VERBINDUNGSGEHÄUSE UND VERFAHREN ZUR HERSTELLUNG DER SCHALTUNG
STRUCTURE DE CIRCUIT POUR BOITIER DE CONNEXION ELECTRIQUE ET PROCEDE D'ELABORATION DU CIRCUIT CORRESPONDANT

(30) Priority: 15.12.2000 JP 2000382569
(43) Date of publication of application: 10.09.2003
(73) Proprietor: YAZAKI CORPORATION, Minato-ku Tokyo 108-8333 (JP)
(72) Inventor: MURAKOSHI, Hiroyuki, Yazaki Parts Co., Ltd., Kosai-shi, Shizuoka 431-0431 (JP)
(74) Representative: HOFFMANN EITLE
(86) International application number: PCT/JP2001/010691
(87) International publication number: WO 2002/049407

(56) References cited:
- DE-C- 652 197
- FR-A- 2 785 453
- GB-A- 986 857
- GB-A- 1 123 027

## Description

### TECHNICAL FIELD

The present invention relates to both circuit structure and circuit forming method for an electrical connection box which is used for interconnection of wire-harness etc.

### BACKGROUND ART

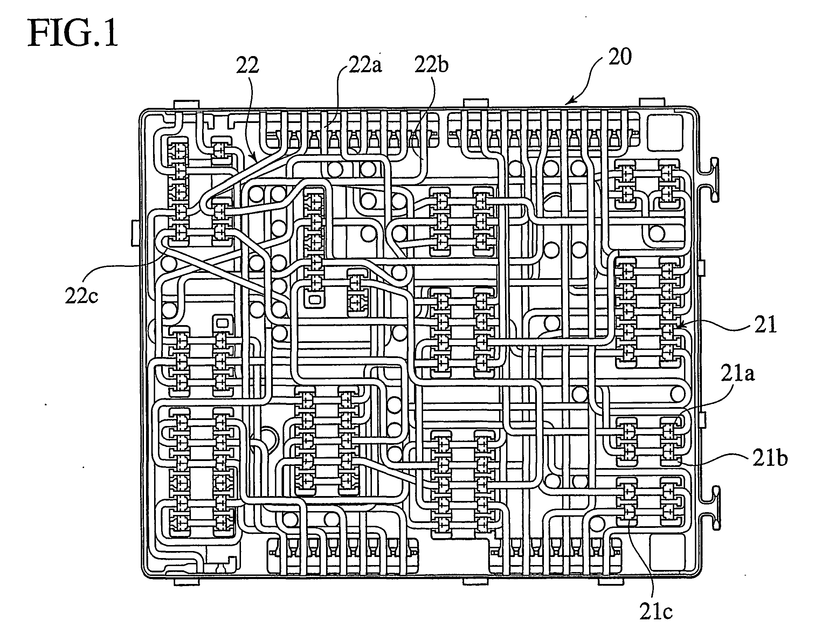

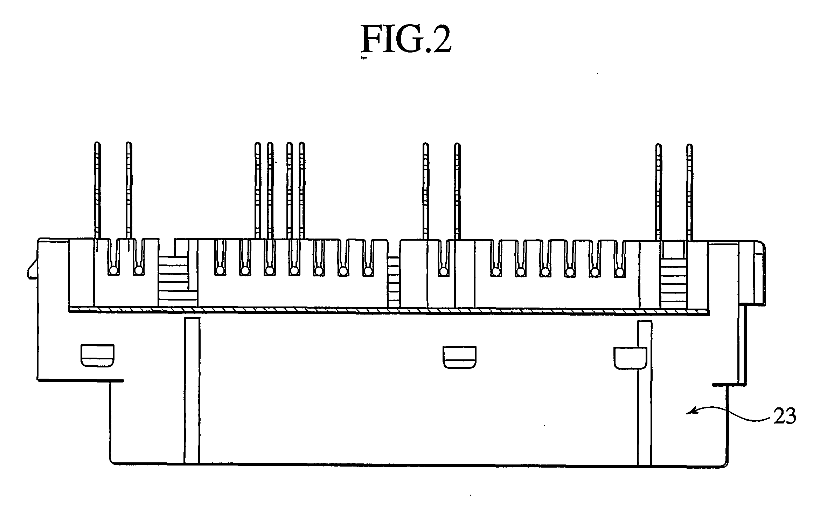

FIG. 1 is a plan view showing the circuit structure for a conventional electrical connection box, showing an illustrative example of a circuit formed on a wiring board. In the circuit structure for the electrical connection box shown in FIG. 1, a plurality of pressure-welding terminals 21 (21a, 21b, 21c,...) are arranged on the wiring board 20 made from an insulating substrate, while a plurality of wires 22 (22a, 22b, 22c,...) are pressure-fitted to the pressure-welding terminals 21 (21a, 21b, 21c,...) for connection, establishing a desired branch circuit. The so-established circuit structure is accommodated in a receiving casing 23 shown in FIG. 2.

On the wiring board 20, the plural wires 22 (22a, 22b, 22c,...) are wired just like curved lines. At wires' intersections existing among the pressure-welding terminals 21 (21a, 21b, 21c,...), these wires 22 (22a, 22b, 22c,...) are laid to overlap each other.

For the above-mentioned conventional circuit structure where the plural wires 22 (22a, 22b, 22c,...) are wired like curved lines, however, a wiring machine has to turn its wiring head for the wires 22 (22a, 22b, 22c,...) at their bending points in the course of wiring the wires among the pressure-welding terminals 21 (21a, 21b, 21c,...) while taking a lot of time for the wiring operation. Consequently, there arises a problem that a requirement of establishing more wiring machines would cause the installation cost to be increased.

Additionally, since the plural wires 22 (22a, 22b, 22c,...) overlap each other at the intersections, a space that the wiring board 20 occupies in height is increased as the number of wires overlapping increases, causing the electrical connection box to be large-sized. Contrary, if the number of wires 22 (22a, 22b, 22c,...) overlapping is restricted to prevent the above problem, then there arises a new problem of difficulty to arrange the wires on the wiring board.

According to a first aspect of the present invention, there is provided a circuit structure for an electrical connection box, comprising: a wiring board having an insulating substrate; a plurality of first wires wired straight in a first direction defined on the wiring board at predetermined intervals; a plurality of second wires wired straight in a second direction defined on the wiring board at predetermined intervals, the second wires crossing the first wires at respective intersections; and
a plurality of pressure-welding terminals supported on the insulating substrate, for electrically connecting the first wires with the second wires; wherein the pressure-welding terminals are fitted on some of the intersections under pressure thereby to establish a designated circuit on the wiring board.

Optionally, in the above circuit structure, the first wires and the second wires are together covered with insulating covers respectively.

Optionally, in the above circuit structure, the first direction is identical to a horizontal direction defined on the wiring board and the second direction is identical to a vertical direction substantially perpendicular to the horizontal direction.

According to a second aspect of the present invention, there is further provided a method of forming a designated circuit for electrical connection box by using a wiring machine having a wiring head, the method comprising the steps of: preparing a first wires and a wiring board having an insulating board and further allowing the wiring machine to retain the first wires; operating the wiring machine to wire the first wires on the wiring board straight in a first direction defined on the wiring board, at predetermined intervals through the wiring head; preparing a second wires and further allowing the wiring machine to retain the second wires; operating the wiring machine to wire the second wires on the wiring board straight in a second direction defined on the wiring board, at predetermined intervals through the wiring head so that the second wires cross the first wires at respective intersections; and preparing a plurality of pressure-welding terminals for electrically connecting the first wires with the second wires and further fitting the pressure-welding terminals on some of the intersections under pressure thereby to establish the designated circuit on the wiring board.

Optionally, the wiring machine has a plurality of wiring heads juxtaposed therein and the method further comprises the following steps: the wiring machine simultaneously wires the first wires on the wiring board straight in a first direction defined on the wiring board, at predetermined intervals through the wiring heads juxtaposed; and the wiring machine simultaneously wires the second wires on the wiring board straight in a second direction defined on the wiring board, at predetermined intervals through the wiring heads juxtaposed.

According to a third aspect of the present invention, there is also provided a circuit structure for electrical connection box, comprising: a wiring board having an insulating substrate; a plurality of first wires wired straight in a first direction defined on the wiring board at predetermined intervals; and a plurality of second wires wired straight in a second direction defined on the wiring board at predetermined intervals, the second wires crossing the first wires at respective intersections; wherein, at the some intersections, the first wires are welded to the second wires respectively for effecting electrical conductivity between the first wires and the second wires thereby to establish a designated circuit on the wiring board; the first wires and the second wires are together covered with insulating covers respectively; and at some of the intersections, the first wires are connected with the second wires respectively under condition that the insulating covers of the first and second wires have been fused.

Optionally, the first direction is identical to a horizontal direction defined on the wiring board and the second direction is identical to a vertical direction substantially perpendicular to the horizontal direction.

According to a fourth aspect of the present invention, there is further provided a method of forming a designated circuit for electrical connection box by using a wiring machine, the method comprising the steps of: preparing a first wires and a wiring board having an insulating board and further allowing the wiring machine to retain the first wires; operating the wiring machine to wire the first wires on the wiring board straight in a first direction defined on the wiring board, at predetermined intervals; preparing a second wires and further allowing the wiring machine to retain the second wires; operating the wiring machine to wire the second wires on the wiring board straight in a second direction defined on the wiring board, at predetermined intervals so that the second wires cross the first wires at respective intersections; and connecting the first wires to the second wires at some of the intersections thereby to establish the designated circuit on the wiring board, wherein
the first wires and the second wires are together covered with insulating covers respectively; and wherein
the connecting step includes a step of fusing the insulating covers of the first and second wires.

Optionally, the step of fusing the insulating covers can be performed by ultrasonic welding.

These and other features of embodiments of the present invention will become more fully apparent from the following description and appended claims taken in conjunction with the accompany drawings.

### BRIEF DESCRIPTION OF THE DRAWINGS

For a better understanding of the invention and to show how the same may be carried into effect, reference will now be made, by way of example, to the accompanying drawings, in which:
FIG. 1 is a plan view showing the circuit structure of the electrical connection box as an example of the prior art;
FIG. 2 is a side view of FIG. 1;
FIG. 3 is a plan view showing the circuit structure of the electrical connection box in accordance with the first embodiment of the present invention;
FIG. 4 is a longitudinal sectional view of FIG. 3;
FIG. 5 is a perspective view showing a condition that necessary one of intersections defined by the wires in the horizontal direction and the wires in the vertical direction, is conducted electrically through a pressure-welding terminal; and
FIG. 6 is a perspective view showing a condition that the wires forming one intersection defined by one wire in the horizontal direction and another wire in the vertical direction, are welded with each other.

In consideration of the above-mentioned problems, the embodiments of the invention, described below, provide both circuit structures and circuit forming methods for electrical connection boxes, both of which can provide both improved workability in arranging the wires and reduced installation cost and furthermore, which can save a space occupied by the wired wires in height.

In the following circuit structure, the afore-mentioned bending points of the wires can be eliminated since the first and second wires are wired straight in two directions: the first direction and the second directions crossing the first direction at the intersections. Thus, since it becomes unnecessary to turn the wiring head in the course of wiring the wires by the wiring machine, it is possible to shorten the period required for the wiring operation. Correspondingly, it becomes possible to reduce the number of wiring machines, also reducing the installation cost.

Additionally, owing to the above-mentioned arrangement of the first and second wires, each overlap of these wires consists of two wires at most, so that the wiring board can be lowered in height thereby to save a space occupied by the wiring board in height.

Furthermore, it is possible to establish the designated circuit without using the pressure-welding terminals, improving the workability in connecting the wires.

According to the disclosed methods of forming a circuit structure for electrical connection, the bending points of the wires can be eliminated since the first and second wires are wired straight at predetermined intervals and juxtaposed in the first and second directions.

Thus, since it becomes unnecessary to turn the wiring head in the course of wiring the wires by the wiring machine, it is possible to shorten a period required for the wiring operation. Correspondingly, it becomes possible to reduce the number of wiring machines, also reducing the installation cost.

Additionally, owing to the above-mentioned arrangement of the first and second wires, each overlap of the wires consists of two wires at most, so that the wiring board can be lowered in height thereby to save a space occupied by the wiring board in height.

In various embodiments, it is possible to shorten a period of the wiring operation remarkably since the first and second wires are respectively wired by the juxtaposed wiring heads simultaneously. Thus, it is possible to improve the workability in wiring furthermore.

Accordingly, when the designated circuit is formed without using the pressure-welding terminals, it is possible to improve the workability in connecting the first wires to the second wires.

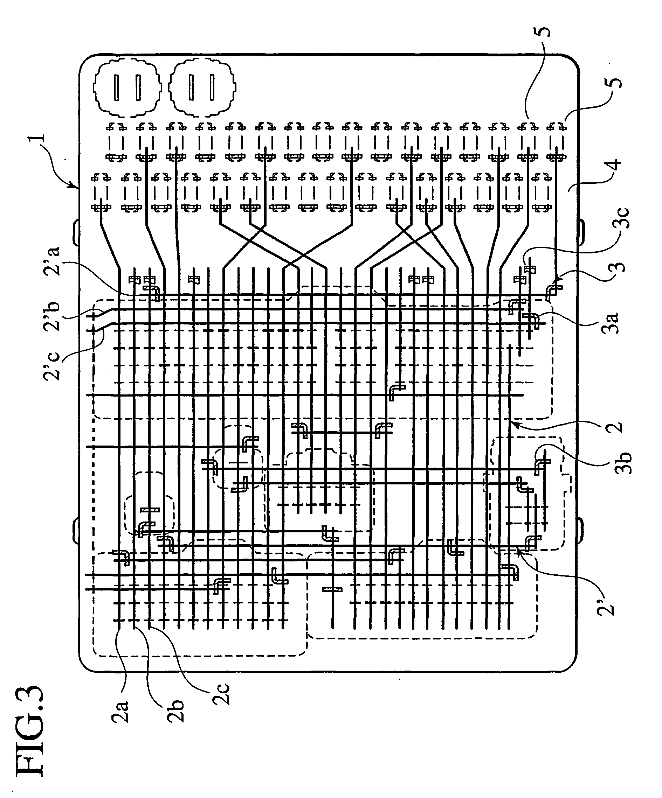

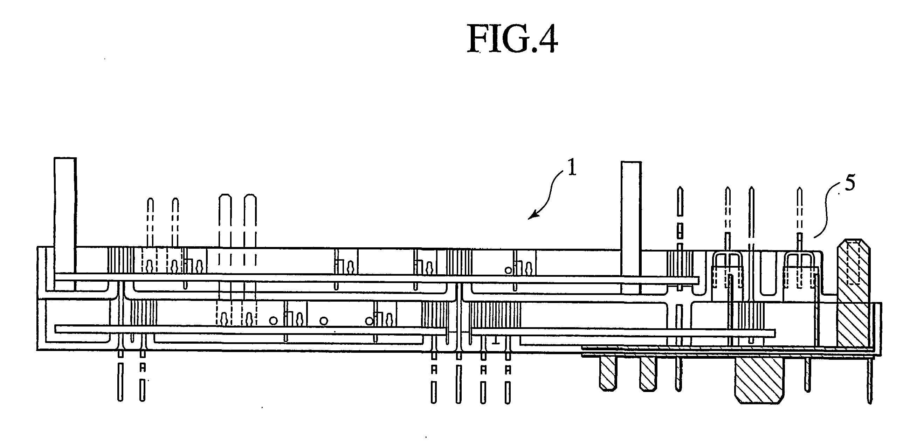

As shown in FIGS. 3 and 4, the circuit structure for an electrical connection box includes a wiring board 1, a plurality of first wires 2, a plurality of second wires 2' and a plurality of pressure-welding terminals 3. The wiring board 1 is made from an insulating substrate 4. In the assembled state shown in the figure, The pressure-welding terminal 3 (3a, 3b, 3c,...) are fitted and supported on the insulating substrate 4. In the embodiment, the first wires 2 (2a, 2b, 2c, ...) are wired straight in a first direction (i.e. horizontal direction in the figure) on the wiring board 1. The wires 2 (2a, 2b, 2c, ...) are parallel with each other at predetermined intervals. While, the second wires 2' (2'a, 2'b, 2'c, ...) are wired straight in a second (vertical) direction on the wiring board 1. Similarly, the wires 2' (2'a, 2'b, 2'c, ...) are parallel with each other at predetermined intervals. In detail, the above horizontal direction of the embodiment is defined to cross the vertical direction at right angles. Consequently, there are established a number of intersections between the first and second wires 2 on the wiring board 1.

In order to form a designated circuit on the wiring board 1, some of the intersections are selected and thereafter, the first and second wires forming each intersection on selection are electrically connected with each other by welding the pressure-welding terminal 3 (3a, 3b, 3c, ...) to them under pressure.

Note, reference numeral 5 in the figure designates an electrical fuse.

Next, the method of forming the above circuit will be described.

First, by means of a not-shown wiring machine with a wiring head, it is performed to wire the first wires 2 (2a, 2b, 2c, ...) one by one straight so as to extend parallel with each other in the horizontal direction on the wiring board 1 at the predetermined intervals.

Next, using the same wiring head, it is further performed to wire the second wires 2' (2'a, 2'b, 2'c, ...) one by one straight so as to extend parallel with each other in the vertical direction crossing the above wiring direction at right angles, at the predetermined intervals.

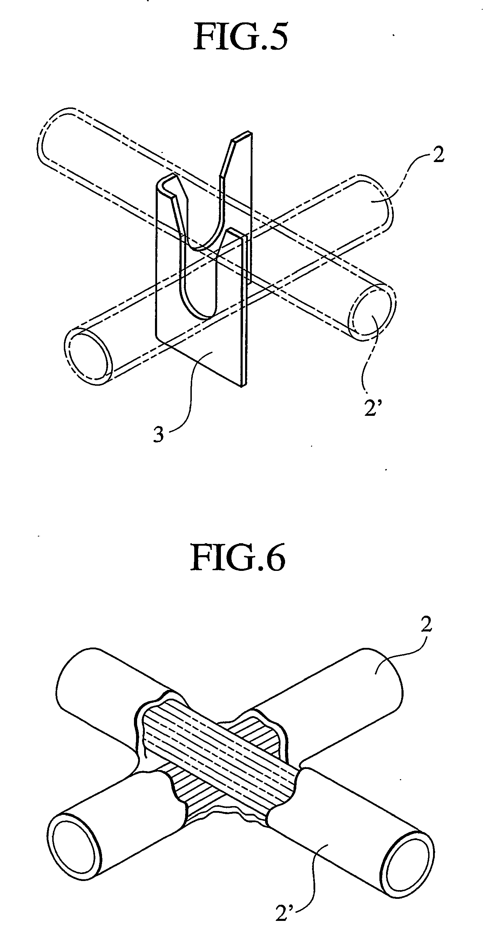

Then, as mentioned above, the essential intersections formed by the first wires 2 (2a, 2b, 2c, ...) of the horizontal direction and the second wires 2' (2'a, 2'b, 2'c, ...) of the vertical direction are welded under pressure by the pressure-welding terminal 3 (3a, 3b, 3c, ...) for respective conductivity, as shown in Fig. 5. In this way, the desired circuit can be established on the wiring board.

Repeatedly, the essential intersections are welded under pressure by the pressure-welding terminal 3 (3a, 3b, 3c, ...) in the above-mentioned embodiment. In the modification, as representatively shown in Fig. 6, the first wire 2 may be connected to the second wire 2' directly without using any pressure-welding terminal. As means for accomplishing such a direct connection between the first and second wires 2 and 2', for example, there exists an ultrasonic welding machine which can fuse insulating covers of the wires 2 and 2' to connect their conductive parts (core lines) with each other. As a matter of course, it is noted that the wires 2 and 2' have to be laid to overlap each other in advance of ultrasonic welding of the wires by the ultrasonic welding machine.

In common with the embodiment and the modification, it is possible to eliminate the bending points that have been commonly associated with the conventional circuit structure since the first wires 2 (2a, 2b, 2c, ...) and the second wires 2' (2'a, 2'b, 2'c, ...) are wired straight in two directions: horizontal direction on the wiring board 1 and vertical direction crossing the horizontal direction at right angles. In other words, it becomes unnecessary to turn the wiring head in the course of wiring the wires by the wiring machine. Therefore, it is possible to shorten a period required for the wiring operation.

Correspondingly, it becomes possible to reduce the number of wiring machines, also reducing the installation cost.

Repeatedly, the first wires 2 are wired straight in the horizontal direction on the wiring board 1 and the second wires 2' are wired straight in the vertical direction crossing the wiring direction of the first wires 2 at right angles. Thus, each overlap of the wires 2, 2' consists of two wires at most, so that the wiring board 1 can be lowered in height to save the space occupied by the board 1 in height.

The above embodiment (including the modification of Fig. 6) is an example illustrative of wiring the wires one by one at predetermined intervals by using the single wiring head. Now, we describe an example of using a not-shown wiring machine having a plurality of wiring heads juxtaposed therein.

Upon juxtaposing the plural wiring heads in the not-shown wiring machine, it is established that the interval of the adjoining wiring heads becomes equal to an interval of the adjoining wires. Thereupon, by using the plural wiring heads, the first wires 2 (2a, 2b, 2c,...) are wired and juxtaposed in the horizontal direction on the wiring board 1 straight and simultaneously. Similarly, the second wires 2' (2'a, 2'b, 2c,...) are wired and juxtaposed in the vertical direction on the wiring board 1 straight and simultaneously. Then, some intersections essential to the designated circuit are electrically connected with each other by the pressure-welding terminals 3 (3a, 3b, 3c...) or ultrasonic welding.

In addition to effects similar to those in the circuit-forming method of the above embodiment, the first and second wires 2 and 2' are wired by the juxtaposed wiring heads simultaneously. Therefore, it is possible to shorten the period of wiring operation remarkably, thereby improving the workability of wiring furthermore.

Although the above embodiment is an example illustrative of wiring the covered wires, the above method is also applicable to form the circuit in case of wiring flat cables on the wiring board.

Further, the above embodiment is an example illustrative of wiring the horizontal and vertical wires crossing at right angles. Nevertheless, the wires in the horizontal and vertical directions do not always cross at right angles so long as they cross each other. Again, although the above embodiment is an example illustrative of wiring the wires on the flat wiring board, they may be wired on a curved wiring board allowing of the straight wiring.

Additionally, the wires in the horizontal direction may be laid on the wires in the vertical direction, and vice versa.

Finally, it will be understood by those skilled in the art that the foregoing description is of preferred embodiments of the disclosed circuit structure and method of forming the circuit. Various changes and modifications may be made to the disclosed embodiments without departing from the scope of the invention.

## Claims

1. A circuit structure for an electrical connection box, comprising:
a wiring board (1) having an insulating substrate;
a plurality of first wires (2, 2a, 2b, 2c) wired straight in a first direction defined on the wiring board at predetermined intervals;
a plurality of second wires (2', 2'a, 2'b, 2'c) wired straight in a second direction defined on the wiring board at predetermined intervals, the second wires crossing the first wires at respective intersections; and
a plurality of pressure-welding terminals (3, 3a, 3b, 3c) supported on the insulating substrate, for electrically connecting the first wires with the second wires;
wherein the pressure-welding terminals (3, 3a, 3b, 3c) are fitted on some of the intersections under pressure thereby to establish a designated circuit on the wiring board (1).

2. A circuit structure for an electrical connection box as claimed in claim 1, wherein the first wires (2, 2a, 2b, 2c) and the second wires (2', 2'a, 2'b, 2'c) are together covered with insulating covers respectively.

3. A circuit structure for an electrical connection box as claimed in claims 1 or 2, wherein the first direction is identical to a horizontal direction defined on the wiring board (1) and the second direction is identical to a vertical direction substantially perpendicular to the horizontal direction.

4. A method of forming a designated circuit for an electrical connection box by using a wiring machine having a wiring head, the method comprising the steps of:
preparing a first wires (2, 2a, 2b, 2c) and a wiring board having an insulating board and further allowing the wiring machine to retain the first wires;
operating the wiring machine to wire the first wires (2, 2a, 2b, 2c) on the wiring board straight in a first direction defined on the wiring board, at predetermined intervals through the wiring head;
preparing a second wires (2', 2'a, 2'b, 2'c) and further allowing the wiring machine to retain the second wires;
operating the wiring machine to wire the second wires (2', 2'a, 2'b, 2'c) on the wiring board straight in a second direction defined on the wiring board, at predetermined intervals through the wiring head so that the second wires cross the first wires at respective intersections; and
preparing a plurality of pressure-welding terminals (3, 3a, 3b, 3c) for electrically connecting the first wires with the second wires and further fitting the pressure-welding terminals (3, 3a, 3b, 3c) on some of the intersections under pressure thereby to establish the designated circuit on the wiring board.

5. A method of forming a designated circuit for an electrical connection box as claimed in claim 4, wherein:
the wiring machine has a plurality of wiring heads juxtaposed therein;
the wiring machine simultaneously wires the first wires (2, 2a, 2b, 2c) on the wiring board straight in a first direction defined on the wiring board, at predetermined intervals, through the wiring heads juxtaposed; and
the wiring machine simultaneously wires the second wires (2', 2'a, 2'b, 2'c) on the wiring board straight in a second direction defined on the wiring board, at predetermined intervals, through the wiring heads juxtaposed.

6. A circuit structure for an electrical connection box, comprising:
a wiring board (1) having an insulating substrate;
a plurality of first wires (2, 2a, 2b, 2c) wired straight in a first direction defined on the wiring board at predetermined intervals; and
a plurality of second wires (2', 2'a, 2'b, 2'c) wired straight in a second direction defined on the wiring board at predetermined intervals, the second wires crossing the first wires at respective intersections;
wherein:
at some intersections, the first wires are welded to the second wires respectively for effecting electrical conductivity between the first wires and the second wires thereby to establish a designated circuit on the wiring board;
the first wires and the second wires are together covered with insulating covers respectively; and
at some of the intersections, the first wires are connected with the second wires respectively under condition that the insulating covers of the first and second wires have been fused.

7. A circuit structure for an electrical connection box as claimed in claim 6, wherein the first direction is identical to a horizontal direction defined on the wiring board and the second direction is identical to a vertical direction substantially perpendicular to the horizontal direction.

8. A method of forming a designated circuit for an electrical connection box by using a wiring machine, the method comprising the steps of:
preparing a first wires (2, 2a, 2b, 2c) and a wiring board (1) having an insulating board and further allowing the wiring machine to retain the first wires;
operating the wiring machine to wire the first wires (2, 2a, 2b, 2c) on the wiring board straight in a first direction defined on the wiring board, at predetermined intervals;
preparing a second wires (2', 2'a, 2'b, 2'c) and further allowing the wiring machine to retain the second wires;
operating the wiring machine to wire the second wires (2', 2'a, 2'b, 2'c) on the wiring board straight in a second direction defined on the wiring board, at predetermined intervals so that the second wires cross the first wires at respective intersections; and
connecting the first wires (2, 2a, 2b, 2c) to the second wires (2', 2'a, 2'b, 2'c) at some intersections thereby to establish the designated circuit on the wiring board, wherein the first wires (2, 2a, 2b, 2c) and the second wires (2', 2'a, 2'b, 2'c) are each covered with insulating covers respectively; and wherein the connecting step includes a step of fusing the insulating covers of some of the first wires (2, 2a, 2b, 2c) and second wires (2', 2'a, 2'b, 2'c).

9. A method according to claim 8 wherein the step of fusing the insulating covers is performed by ultrasonic welding.

## Patentansprüche

1. Schaltungsanordnung für einen elektrischen Anschlusskasten, mit:
einer Verdrahtungsplatte (1), die ein isolierendes Substrat aufweist;
einer Vielzahl von ersten Drähten (2, 2a, 2b, 2c), die in vorbestimmten Intervallen in einer ersten Richtung, die auf der Verdrahtungsplatte definiert ist, gerade verdrahtet sind;
einer Vielzahl von zweiten Drähten (2', 2'a, 2'b, 2'c), die in vorbestimmten Intervallen in einer zweiten Richtung, die auf der Verdrahtungsplatte definiert ist, gerade verdrahtet sind, wobei die zweiten Drähte die ersten Drähte an jeweiligen Kreuzungspunkten kreuzen; und
einer Vielzahl von Drucksschweißungsanschlüssen (3, 3a, 3b, 3c), die auf dem isolierenden Substrat gestützt werden, zum elektrischen Verbinden der ersten Drähte mit den zweiten Drähten;
wobei die Druckschweißungsanschlüsse (3, 3a, 3b, 3c) an einigen der Kreuzungspunkte unter Druck angebracht sind, um **dadurch** eine gewünschte Schaltung auf der Verdrahtungsplatte (1) aufzubauen.

2. Schaltungsanordnung für einen elektrischen Anschlusskasten nach Anspruch 1, bei der die ersten Drähte (2, 2a, 2b, 2c) und die zweiten Drähte (2', 2'a, 2'b, 2'c) jeweils zusammen mit isolierenden Bedeckungen bedeckt sind.

3. Schaltungsanordnung für einen elektrischen Anschlusskasten nach Anspruch 1 oder 2, bei der die erste Richtung identisch mit einer horizontalen Richtung ist, die auf der Verdrahtungsplatte (1) definiert ist, und die zweite Richtung identisch mit einer vertikalen Richtung ist, die im Wesentlichen senkrecht zu der horizontalen Richtung ist.

4. Verfahren zum Ausbilden einer gewünschten Schaltung für einen elektrischen Anschlusskasten, unter Verwendung einer Verdrahtungsmaschine mit einem Verdrahtungskopf, wobei das Verfahren die folgenden Schritte umfasst:
Bereitstellen erster Drähte (2, 2a, 2b, 2c) und einer Verdrahtungsplatte, die eine isolierende Platte aufweist, und ferner Zulassen, dass die Verdrahtungsmaschine die ersten Drähte hält;
Betätigen der Verdrahtungsmaschine, um die ersten Drähte (2, 2a, 2b, 2c) auf der Verdrahtungsplatte gerade in einer ersten Richtung zu verdrahten, die auf der Verdrahtungsplatte definiert ist, in vorbestimmten Intervallen mittels des Verdrahtungskopfes;
Bereitstellen zweiter Drähte (2', 2'a, 2'b, 2'c) und ferner Zulassen, dass die Verdrahtungsmaschine die zweiten Drähte hält;
Betätigen der Verdrahtungsmaschine, um die zweiten Drähte (2', 2'a, 2'b, 2'c) auf der Verdrahtungsplatte gerade in einer zweiten Richtung zu verdrahten, die auf der Verdrahtungsplatte definiert ist, in vorbestimmten Intervallen mittels des Verdrahtungskopfes, so dass die zweiten Drähte die ersten Drähte an jeweiligen Kreuzungspunkten kreuzen; und
Bereitstellen einer Vielzahl von Drucksschweißungsanschlüssen (3, 3a, 3b, 3c) zum elektrischen Verbinden der ersten Drähte mit den zweiten Drähten, und ferner Anbringen der Druckschweißungsanschlüsse (3, 3a, 3b, 3c) an einigen der Kreuzungspunkte unter Druck, um **dadurch** die gewünschte Schaltung auf der Verdrahtungsplatte aufzubauen.

5. Verfahren zum Ausbilden einer gewünschten Schaltung für einen elektrischen Anschlusskasten nach Anspruch 4, wobei:
die Verdrahtungsmaschine eine Vielzahl von Verdrahtungsköpfen aufweist, die in ihr nebeneinander liegen;
wobei die Verdrahtungsmaschine gleichzeitig die ersten Drähte (2, 2a, 2b, 2c) auf der Verdrahtungsplatte gerade in einer ersten Richtung verdrahtet, die auf der Verdrahtungsplatte definiert ist, in vorbestimmten Intervallen mittels der nebeneinander liegenden Verdrahtungsköpfe; und
die Verdrahtungsmaschine gleichzeitig die zweiten Drähte (2', 2'a, 2'b, 2'c) auf der Verdrahtungsplatte gerade in einer zweiten Richtung verdrahtet, die auf der Verdrahtungsplatte definiert ist, in vorbestimmten Intervallen mittels der nebeneinander liegenden Verdrahtungsköpfe.

6. Schaltungsanordnung für einen elektrischen Anschlusskasten, mit:
einer Verdrahtungsplatte (1), die ein isolierendes Substrat aufweist;
einer Vielzahl von ersten Drähten (2, 2a, 2b, 2c), die in vorbestimmten Intervallen in einer ersten Richtung, die auf der Verdrahtungsplatte definiert ist, gerade verdrahtet sind;
einer Vielzahl von zweiten Drähten (2', 2'a, 2'b, 2'c), die in vorbestimmten Intervallen in einer zweiten Richtung, die auf der Verdrahtungsplatte definiert ist, gerade verdrahtet sind, wobei die zweiten Drähte die ersten Drähte an jeweiligen Kreuzungspunkten kreuzen;
wobei:
an einigen Kreuzungspunkten die ersten Drähte jeweils an die zweiten Drähte geschweißt sind, zum Bewirken einer elektrischen Leitfähigkeit zwischen den ersten Drähten und den zweiten Drähten, um **dadurch** eine gewünschte Schaltung auf der Verdrahtungsplatte aufzubauen;
wobei die ersten Drähte und die zweiten Drähte jeweils zusammen mit isolierenden Bedeckungen bedeckt sind; und
an einigen der Kreuzungspunkte, die ersten Drähte jeweils mit den zweiten Drähten in dem Zustand verbunden sind, dass die isolierenden Bedeckungen der ersten und zweiten Drähte verschmolzen wurden.

7. Schaltungsanordnung für einen elektrischen Anschlusskasten nach Anspruch 6, bei der die erste Richtung identisch mit einer horizontalen Richtung ist, die auf der Verdrahtungsplatte definiert ist, und die zweite Richtung identisch mit einer vertikalen Richtung ist, die im Wesentlichen senkrecht zu der horizontalen Richtung ist.

8. Verfahren zum Ausbilden einer gewünschten Schaltung für einen elektrischen Anschlusskasten, unter Verwendung einer Verdrahtungsmaschine, wobei das Verfahren die folgenden Schritte umfasst:
Bereitstellen erster Drähte (2, 2a, 2b, 2c) und einer Verdrahtungsplatte (1), die eine isolierende Platte aufweist, und ferner Zulassen, dass die Verdrahtungsmaschine die ersten Drähte hält;
Betätigen der Verdrahtungsmaschine, um die ersten Drähte (2, 2a, 2b, 2c) auf der Verdrahtungsplatte in vorbestimmten Intervallen gerade in einer ersten Richtung zu verdrahten, die auf der Verdrahtungsplatte definiert ist;
Bereitstellen zweiter Drähte (2', 2'a, 2'b, 2'c) und ferner Zulassen, dass die Verdrahtungsmaschine die zweiten Drähte hält;
Betätigen der Verdrahtungsmaschine, um die zweiten Drähte (2', 2'a, 2'b, 2'c) auf der Verdrahtungsplatte in vorbestimmten Intervallen gerade in einer zweiten Richtung zu verdrahten, die auf der Verdrahtungsplatte definiert ist, so dass die zweiten Drähte die ersten Drähte an jeweiligen Kreuzungspunkten kreuzen; und
Verbinden der ersten Drähte (2, 2a, 2b, 2c) mit den zweiten Drähten (2', 2'a, 2'b, 2'c) an einigen Kreuzungspunkten, um **dadurch** die gewünschte Schaltung auf der Verdrahtungsplatte aufzubauen, wobei die ersten Drähte (2, 2a, 2b, 2c) und die zweiten Drähte (2', 2'a, 2'b, 2'c) ein jeder jeweils mit isolierenden Bedeckungen bedeckt sind; und wobei der Verbindungsschritt einen Schritt des Schmelzens der isolierenden Bedeckungen einiger der ersten Drähte (2, 2a, 2b, 2c) und zweiten Drähte (2', 2'a, 2'b, 2'c) umfasst.

9. Verfahren nach Anspruch 8, wobei der Schritt des Schmelzens der isolierenden Bedeckungen durch Ultraschallschweißen durchgeführt wird.

## Revendications

1. Structure de circuit pour un boîtier de connexion électrique, comprenant :
un tableau de connexion (1) ayant un substrat isolant ;
une pluralité de premiers fils (2, 2a, 2b, 2c) câblés en ligne droite dans une première direction définie sur le tableau de connexion à des intervalles prédéterminés;
une pluralité de seconds fils (2', 2'a, 2'b, 2'c) câblés en ligne droite dans une seconde direction définie sur le tableau de connexion à des intervalles prédéterminés, les seconds fils croisant les premiers fils à des intersections respectives ; et
une pluralité de bornes de soudage par pression (3, 3a, 3b, 3c) supportées sur le substrat isolant, pour connecter électriquement les premiers fils aux seconds fils ;
dans laquelle les bornes de soudage par pression (3, 3a, 3b, 3c) sont ajustées sur certaines des intersections sous pression pour établir ainsi un circuit désigné sur le tableau de connexion (1).

2. Structure de circuit pour un boîtier de connexion électrique selon la revendication 1, dans laquelle les premiers fils (2, 2a, 2b, 2c) et les seconds fils (2', 2'a, 2'b, 2'c) sont ensemble recouverts d'enveloppes isolantes respectivement.

3. Structure de circuit pour un boîtier de connexion électrique selon les revendications 1 ou 2, dans laquelle la première direction est identique à une direction horizontale définie sur le tableau de connexion (1) et la seconde direction est identique à une direction verticale sensiblement perpendiculaire à la direction horizontale.

4. Procédé de formation d'un circuit désigné pour un boîtier de connexion électrique en utilisant une machine de câblage ayant une tête de câblage, le procédé comprenant les étapes consistant à :
préparer des premiers fils (2, 2a, 2b, 2c) et un tableau de connexion ayant un panneau isolant et permettre en outre à la machine de câblage de retenir les premiers fils ;
utiliser la machine de câblage pour câbler les premiers fils (2, 2a, 2b, 2c) sur le tableau de connexion en ligne droite dans une première direction définie sur le tableau de connexion, à des intervalles prédéterminés à travers la tête de câblage ;
préparer des seconds fils (2', 2'a, 2'b, 2'c) et permettre en outre à la machine de câblage de retenir les seconds fils ;
utiliser la machine de câblage pour câbler les seconds fils (2', 2'a, 2'b, 2'c) sur le tableau de connexion en ligne droite dans une seconde direction définie sur le tableau de connexion, à des intervalles prédéterminés à travers la tête de câblage de sorte que les seconds fils croisent les premiers fils à des intersections respectives ; et
préparer une pluralité de bornes de soudage par pression (3, 3a, 3b, 3c) pour connecter électriquement les premiers fils aux seconds fils et ajuster en outre les bornes de soudage par pression (3, 3a, 3b, 3c) sur certaines des intersections sous pression pour établir ainsi le circuit désigné sur le tableau de connexion.

5. Procédé de formation d'un circuit désigné pour un boîtier de connexion électrique selon la revendication 4, dans lequel :
la machine de câblage comporte une pluralité de têtes de câblage juxtaposées ;
la machine de câblage câble simultanément les premiers fils (2, 2a, 2b, 2c) sur le tableau de connexion en ligne droite dans une première direction définie sur le tableau de connexion, à des intervalles prédéterminés, à travers les têtes de câblage juxtaposées ; et
la machine de câblage câble simultanément les seconds fils (2', 2'a, 2'b, 2'c) sur le tableau de connexion en ligne droite dans une seconde direction définie sur le tableau de connexion, à des intervalles prédéterminés, à travers les têtes de câblage juxtaposées.

6. Structure de circuit pour un boîtier de connexion électrique, comprenant :
un tableau de connexion (1) ayant un substrat isolant ;
une pluralité de premiers fils 2, 2a, 2b, 2c) câblés en ligne droite dans une première direction définie sur le tableau de connexion à des intervalles prédéterminés ; et
une pluralité de seconds fils (2', 2'a, 2'b, 2'c) câblés en ligne droite dans une seconde direction définie sur le tableau de connexion à des intervalles prédéterminés, les seconds fils croisant les premiers fils à des intersections respectives ;
dans laquelle :
à certaines intersections, les premiers fils sont soudés aux seconds fils respectivement pour créer une conductivité électrique entre les premiers fils et les seconds fils afin d'établir ainsi un circuit désigné sur le tableau de connexion ;
les premiers fils et les seconds fils sont ensemble recouverts d'enveloppes isolantes respectivement ; et
à certaines des intersections, les premiers fils sont connectés aux seconds fils respectivement à condition que les enveloppes isolantes des premiers et seconds fils aient été fusionnées.

7. Structure de circuit pour un boîtier de connexion électrique selon la revendication 6, dans laquelle la première direction est identique à une direction horizontale définie sur le tableau de connexion et la seconde direction est identique à une direction verticale sensiblement perpendiculaire à la direction horizontale.

8. Procédé de formation d'un circuit désigné pour un boîtier de connexion électrique en utilisant une machine de câblage, le procédé comprenant les étapes consistant à :
préparer des premiers fils (2, 2a, 2b, 2c) et un tableau de connexion (1) ayant un panneau isolant et permettre en outre à la machine de câblage de retenir les premiers fils ;
utiliser la machine de câblage pour câbler les premiers fils (2, 2a, 2b, 2c) sur le tableau de connexion en ligne droite dans une première direction définie sur le tableau de connexion, à des intervalles prédéterminés ;
préparer des seconds fils (2', 2'a, 2'b, 2'c) et permettre en outre à la machine de câblage de retenir les seconds fils ;
utiliser la machine de câblage pour câbler les seconds fils (2', 2'a, 2'b, 2'c) sur le tableau de connexion en ligne droite dans une seconde direction définie sur le tableau de connexion, à des intervalles prédéterminés de sorte que les seconds fils croisent les premiers fils à des intersections respectives ; et
connecter les premiers fils (2, 2a, 2b, 2c) aux seconds fils (2', 2'a, 2'b, 2'c) à certaines intersections pour établir ainsi le circuit désigné sur le tableau de connexion, où les premiers fils (2, 2a, 2b, 2c) et les seconds fils (2', 2'a, 2'b, 2'c) sont chacun recouverts d'enveloppes isolantes respectivement ; et où l'étape de connexion comprend une étape de fusion des couvertures isolantes de certains des premiers fils (2, 2a, 2b, 2c) et des seconds fils (2', 2'a, 2'b, 2'c).

9. Procédé selon la revendication 8, dans lequel l'étape de fusion des enveloppes isolantes est effectuée par un soudage ultrasonique.
